# EUROPEAN PATENT APPLICATION

(11) **EP 1 542 265 A1**
(43) Date of publication of application: **15.06.2005**
(21) Application number: 03736139.1
(22) Date of filing: 10.06.2003
(51) Int. Cl.: H01L 21/265

(54) **MASK AND PRODUCTION METHOD THEREFOR AND PRODUCTION METHOD FOR SEMICONDUCTOR DEVICE**

(30) Priority: 26.06.2002 JP 2002186232
(71) Applicant: Sony Corporation, Tokyo 141-0001 (JP)
(72) Inventor: KOIKE, Kaoru c/o SONY CORPORATION, Shinagawa-ku, Tokyo 141-0001 (JP)
(74) Representative: Thévenet, Jean-Bruno
(86) International application number: PCT/JP2003/007377
(87) International publication number: WO 2004/003985

(57) **Abstract**

A highly durable mask with sufficient strength against ion implantation, a method of producing the same, and a method of producing a semiconductor device using the mask are provided. A mask comprising a thin film, a protective film preferably composed of a photosensitive resin formed on a part of the thin film, a supporting frame formed on the thin film to surround the protective film, and holes formed in the thin film and the protective film for allowing a charged particle beam or a electromagnetic wave irradiated on the protective film side to pass; the method of producing the same; and a method of producing a semiconductor device including an ion implantation step using the same.

## Description

### TECHNICAL FIELD

The present invention relates to a mask, a method of producing the same, and a method of producing a semiconductor device, and particularly relates to a mask used in an ion implantation step, a method of producing the same, and a method of producing a semiconductor device wherein a stencil mask is used for ion implantation.

### BACKGOUND ART

In production of a semiconductor device, an ion implantation step is essential for producing a channel region, etc. However, there is a problem that a resist changes in quality due to ions implanted to the resist in the ion implantation step and the resist becomes hard to be peeled off after the ion implantation step. Also, when using the resist as a mask for ion implantation, a series of steps, such as resist application step, lithography step and resist peeling step, becomes necessary, which leads to an increase of a production cost of a semiconductor device.

As a method of solving those problems, an ion implantation method using a stencil mask has been presented in 2000 IEEE International Electron Devices Meeting (2000 IEDM). According to the technique thereof, ions are implanted to a desired position by using a stencil mask (a mask having openings).

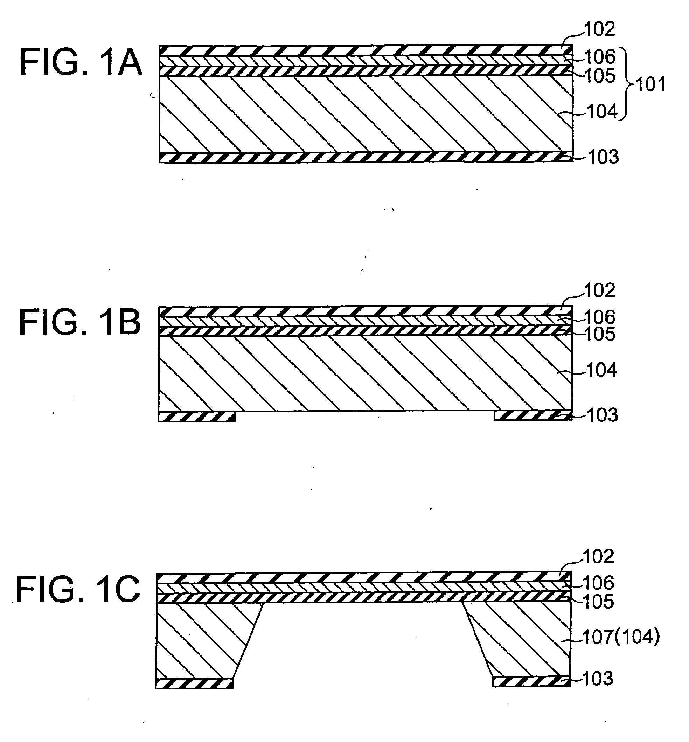

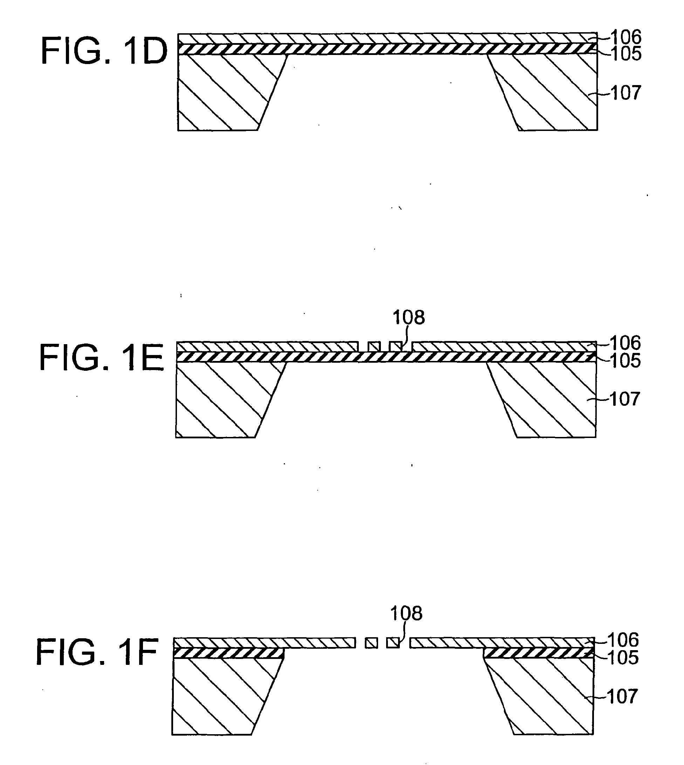

An example of a production method of a conventional stencil mask for ion implantation will be explained with reference to FIGs. 1A to 1F. First, as shown in FIG. 1A, silicon nitride films 102 and 103 are formed on both surfaces of a SOI substrate 101. The SOI substrate 101 has a silicon layer 106 on a silicon substrate 104 via a silicon oxide film 105. The silicon nitride film 103 is used as an etching mask when performing etching on the silicon substrate 104.

Alternately, silicon oxide films may be formed instead of the silicon nitride films 102 and 103. Film thicknesses of the silicon nitride films 102 and 103 (or silicon oxide films) are, for example, 10 to 1000 nm or so, which are determined by taking into consideration a thickness of the silicon substrate 104, etc. Here, for example, silicon nitride films 102 and 103 having a film thickness of 200 nm are formed.

Next, as shown in FIG. 1B, a photoresist (not shown) is formed on a back surface of the silicon substrate 104 via the silicon nitride film 103, and dry etching is performed on the silicon nitride film 103 by using the photoresist as a mask. After removing the silicon nitride film 103 in a membrane formation region, the photoresist is removed.

Next, as shown in FIG. 1C, for example, wet etching is performed on the silicon substrate 104 by using the silicon nitride film 103 as a mask, and the silicon substrate 104 in the membrane formation region is removed. As a result, a supporting frame (frame) 107 made by the silicon substrate 104 is formed. The silicon oxide film 105 has a role of an etching stopper layer in the etching on the silicon substrate 104.

Next, as shown in FIG. 1D, silicon nitride films 102 and 103 are removed. Continuously, as shown in FIG. 1E, after forming a photoresist (not shown) having openings of an ion implantation pattern on the surface of the silicon layer 106, dry etching is performed on the silicon layer 106 by using the photoresist as a mask. After forming holes 108 in the silicon layer 106, the photoresist is removed.

After that, as shown in FIG. 1F, the silicon oxide film 105 is subjected to dry etching or wet etching from the back surface side (the frame 107 side), and the silicon oxide film 105 in the membrane portion is removed. For example, CF₄ can be used for the dry etching. For example, hydrofluoric acid (HF) can be used for the wet etching. From the above steps, a stencil mask able to be used for ion implantation is produced.

However, when performing ion implantation by using the above stencil mask, ions are implanted also to the mask itself, so that mask strength is deteriorated in accordance with a dose amount of ion implantation. As a method of improving mechanical strength of a stencil mask for transferring used in electron beam lithography and ion beam lithography, etc., for example, methods of providing a metal conductive layer or multilayer dielectric coating to the mask are known. However, even in the case of reinforcing the mask by these methods, sufficient durability for practical purposes cannot be obtained in ion implantation of a large dose amount.

### DISCLOSURE OF THE INVENTION

The present invention was made in consideration of the above problems and has as an object thereof to provide a high-durable mask with sufficient strength against ion implantation, a method of producing the same, and a method of producing a semiconductor device using such a mask.

To attain the above object, a mask of the present invention has a thin film, a protective film formed on a part of the thin film, a supporting frame formed on the thin film to surround the protective film, and holes formed in the thin film and the protective film for allowing a charged particle beam or a electromagnetic wave irradiated on the protective film side to pass.

As a result, energy of the charged particle beam irradiated on the thin film is absorbed by the protective film, and the thin film can obtain an enhanced lifetime. When the protective film is deteriorated by irradiation of the charged particle beam, it is possible to exchange only the protective film. Accordingly, a cost for producing the mask in the production of a semiconductor device can be reduced.

Alternately, a mask of the present invention has a first thin film, a supporting frame formed on a part of a first surface of the first thin film, a second thin film formed on a second surface of the first thin film, and holes formed in the first and second thin films in a portion surrounded by the supporting frame for allowing a charged particle beam or a electromagnetic wave irradiated on the first surface side to pass, wherein impurities are introduced into at least one of the first thin film and the second thin film to control a internal stress thereof.

As a result, durability of the mask against the charged particle beam irradiated to the thin film can be improved. Accordingly, the mask can obtain an enhanced lifetime.

To attain the above object, a method of producing a mask of the present invention has the steps of, forming a thin film on a substrate via a sacrificial film, forming a supporting frame made by the substrate by removing a part of the substrate until the sacrificial film is exposed, forming first holes in the thin film in a portion where the supporting frame is not formed, removing the sacrificial film in the portion where the supporting frame is not formed, forming a protective film on a first surface of the thin film being supporting frame side in the portion where the supporting film is not formed, forming second holes self-aligned to the first holes in the protective film.

Alternately, a method of producing a mask of the present invention has the steps of, forming a first thin film on a substrate via a sacrificial film, introducing impurities into the first thin film for adjusting an internal stress of the first thin film, forming a second thin film on the first thin film, forming a supporting frame made by the substrate by removing a part of the substrate until the sacrificial film is exposed, forming holes in the first thin film and the second thin film in a portion where the supporting frame is not formed, removing the sacrificial film in the portion where the supporting frame is not formed.

As a result, a mask having high durability against irradiation of the charged particle beam or electromagnetic wave can be produced.

Furthermore, to attain the above object, a method of producing a semiconductor device of the present invention includes a step of performing an ion implantation via a mask on a desired portion of a substrate, wherein a mask comprising a thin film, a protective film formed on a part of the thin film, a supporting frame formed on the thin film to surround the protective film, and holes formed in the thin film and the protective film for allowing a charged particle beam or a electromagnetic wave irradiated on the protective film side to pass is used as the mask.

Alternately, a method of producing a semiconductor device of the present invention includes a step of performing an ion implantation via a mask on a desired portion of a substrate, wherein a mask comprising a first thin film, a supporting frame formed on a part of a first surface of the first thin film, a second thin film formed on a second surface of the first thin film, and holes formed in the first and second thin films in a portion surrounded by the supporting frame for allowing a charged particle beam or a electromagnetic wave irradiated on the first surface side to pass, wherein impurities are introduced into at least one of the first thin film and the second thin film to control a internal stress thereof is used as the mask.

As a result, damages on the mask due to the ion implantation are reduced and the mask can obtain an enhanced lifetime. Also, according to the method of producing a semiconductor device of the present invention, a resist for ion implantation is unnecessary and a cost and time for producing a semiconductor device can be largely reduced.

### BRIEF DESCRIPTION OF DRAWINGS

FIG. 1A to FIG. 1F are sectional views showing production steps of a conventional method of producing a mask.
FIG. 2 is a sectional view of a mask according to the embodiment 1 of the present invention.
FIG. 3A to FIG. 3L are sectional views showing production steps of a method of producing a mask according to the embodiment 1 of the present invention.
FIG. 4 is a sectional view of a mask according to the embodiment 2 of the present invention.
FIG. 5A to FIG. 5H are sectional views showing production steps of a method of producing the mask according to the embodiment 2 of the present invention.
FIG. 6 is a flowchart showing a method of producing a semiconductor device according to the embodiment 3 of the present invention.
FIG. 7 is a flowchart showing a method of producing a semiconductor device according to the embodiment 4 of the present invention.

### BEST MODE FOR CARRYING OUT THE INVENTION

Below, preferred embodiments of a mask, a method of producing the same and a method of producing a semiconductor device of the present invention will be explained with reference to the drawings.

### Embodiment 1

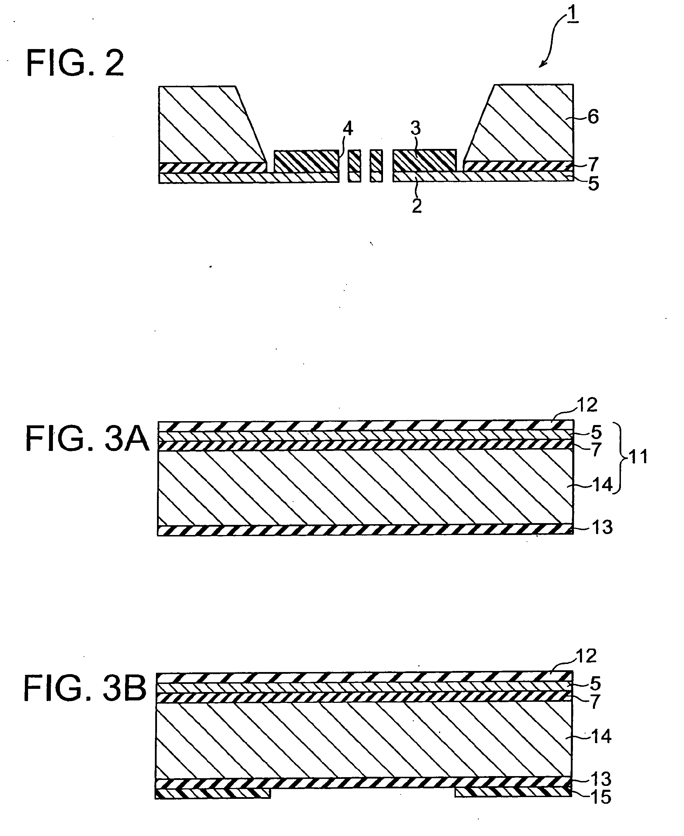

FIG. 2 is a sectional view of a mask of the present embodiment. A stencil mask 1 has a protective film 3 on a membrane 2, and the membrane 2 and the protective film 3 are formed with holes 4 for an ion beam to pass through. When performing ion implantation by using the stencil mask 1, the ion beam is irradiated on the protective film 3 side, passed through the holes 4, then, implanted at a desired position of a semiconductor substrate arranged on the membrane 2 side.

The membrane 2 is a part of a silicon layer 5 and supported by a supporting frame (frame) 6. A silicon oxide film 7 between the silicon layer 5 and the frame 6 is used as an etching stopper layer in a step of forming the frame 6. The protective film 3 is formed on a surface of the membrane 2 on the side irradiated with the ion beam. As the stencil mask 1 of the present embodiment 1, for example, a polymethyl methacrylate (methacrylic resin) (PMMA) film having a thickness of 10 µm is used as the protective film 3, but other resin film may be also used.

When using a photosensitive resin film as the protective film, as will be explained later on, holes are formed on the protective film by exposure, on the other hand, while when forming holes by performing etching on the protective film, a material of the protective film is not limited to a photosensitive resin. As far as it can be peeled off without damaging the membrane 2, a protective film made by a material other than resins may be formed.

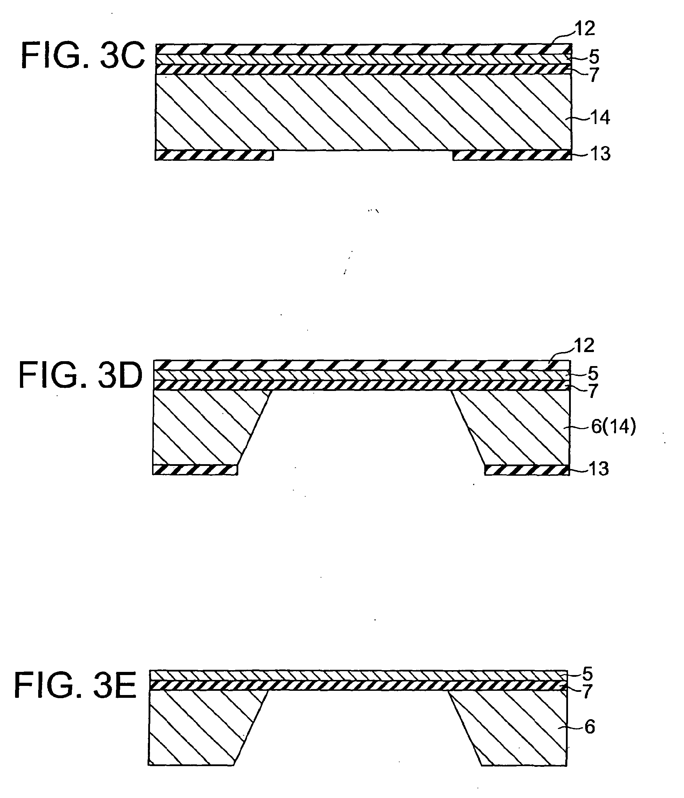

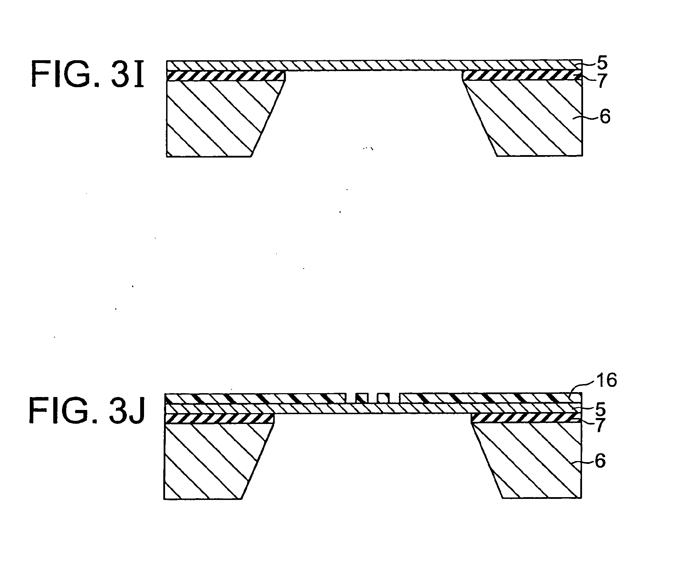

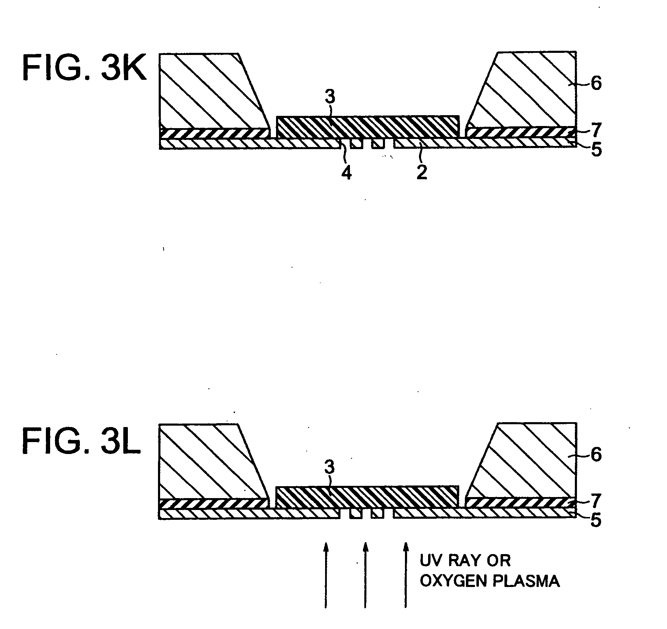

Next, a production method of the mask of the present embodiment explained above will be explained with reference to FIGs. 3A to 3L. First, as shown in FIG. 3A, for example, silicon nitride films 12 and 13 are formed on both surfaces of a SOI substrate 11. The SOI substrate 11 has a silicon layer 5 on a silicon substrate 14 via a silicon oxide film 7. The silicon nitride film 13 is used as an etching mask when performing etching on the silicon substrate 14.

Alternately, silicon oxide films may be formed instead of the silicon nitride films 12 and 13. Film thicknesses of the silicon nitride films 12 and 13 (or silicon oxide films) are, for example, 10 to 1000 nm or so, which are determined by taking into consideration a thickness of the silicon substrate 14, etc. Here, silicon nitride films 12 and 13 having a film thickness of, for example, 200 nm are formed.

Next, as shown in FIG. 3B, after applying a photoresist on the back surface of the silicon substrate 14 via the silicon nitride film 13, exposures and development are performed to from a photoresist 15 having windows in a membrane formation region is formed.

Next, as shown in FIG. 3C, dry etching is performed on the silicon nitride film 13 by using the photoresist 15 as a mask, and a pattern of the photoresist 15 is transferred to the silicon nitride film 13, then, the photoresist 15 is removed.

Next, as shown in FIG. 3D, etching is performed on the silicon substrate 14 by using the silicon nitride film 13 as a mask, and the silicon substrate 14 in the membrane formation region is removed. Consequently, a frame 6 made by the silicon substrate 14 is formed. The etching may be attained, for example, by wet etching using potassium hydroxide (KOH) or tetramethylammonium hydroxide (TMAH), or dry etching using a fluorine based gas. The silicon oxide film 7 has a role of an etching stopper layer in the etching of the silicon substrate 14.

Next, as shown in FIG. 3E, the silicon nitride films 12 and 13 are removed. The silicon nitride films 12 and 13 can be removed, for example, by wet etching using hot phosphoric acid.

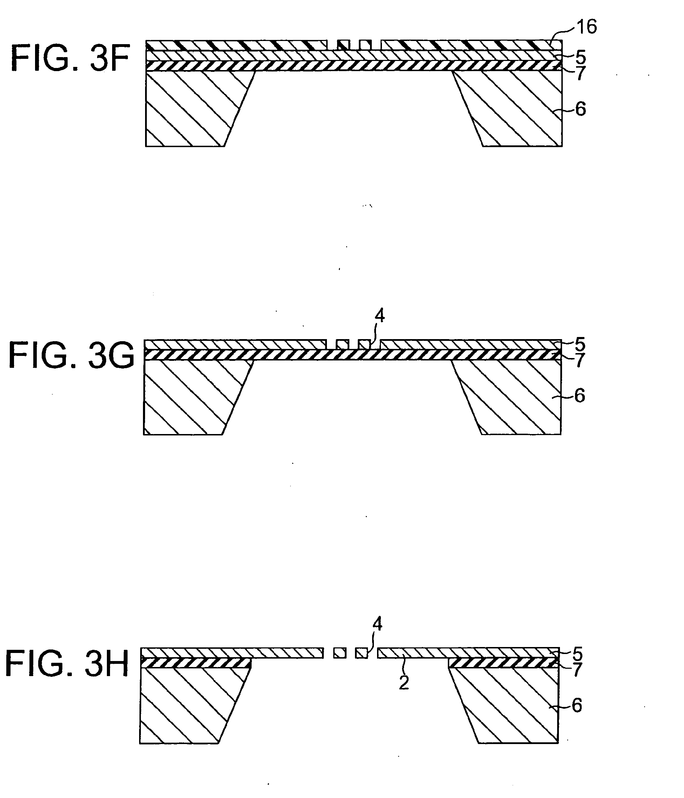

Next, as shown in FIG. 3F, after applying a photoresist to the surface of the silicon layer 5, exposure and development are performed, and a photoresist 16 having windows in an ion implantation pattern is formed.

Next, as shown in FIG. 3G, the photoresist 16 is used as a mask to perform dry etching on the silicon layer 5, and the pattern of the photoresist 16 is transferred to the silicon layer 5. As a result, the silicon layer 5 is formed with holes 4. After that, the photoresist 16 is removed.

Next, as shown in FIG. 3H, dry etching or wet etching is performed on the silicon oxide film 7 from the back surface side (the frame 6 side), and the silicon oxide film 7 on the membrane portion is removed. In the dry etching, for example, CF₄ can be used. In the wet etching, for example, hydrofluoric acid (HF) can be used. From the above steps, a membrane 2 having holes 4 can be formed.

Note that the steps shown in FIG. 3F to FIG. 3H can be changed as below. After removing the silicon nitride films 12 and 13 as shown in FIG. 3E, dry etching or wet etching is performed on the silicon oxide film 7 from the back surface side (the frame 6 side) as shown in FIG. 3I, dry etching or wet etching is performed on the silicon oxide film 7 from the back surface side (the frame 6 side), and the silicon oxide film 7 in the membrane portion is removed. In the dry etching, for example, CF₄ can be used. In the wet etching, for example, hydrofluoric acid (HF) can be used.

Next, as shown in FIG. 3J, after applying a photoresist on the surface of the silicon layer 5, exposure and development are performed, and a photoresist 16 having windows in an ion implantation pattern is formed.

Next, the photoresist 16 is used as a mask to perform dry etching on the silicon layer 5, and the pattern of the photoresist 16 is transferred to the silicon layer 5. As a result, holes 4 are formed on the silicon layer 5. After that, by removing the photoresist 16, a membrane 2 having holes 4 is formed as shown in FIG. 3H. As explained above, the silicon oxide film 7 in the membrane portion may be removed before forming the holes 4.

Next, as shown in FIG. 3K, a protective film 3 is adhered to the surface irradiated with an ion beam of the membrane 2. Here, as the protective film 3, PMMA formed to be a film shape in advance and cut to be a size of covering the membrane 2 is used. The size of the protective film 3 does not have to be the same size as that of the membrane 2 and may be a size of covering a portion irradiated with an ion beam on the membrane 2. A thickness of the protective film 3 is determined in accordance with accelerating energy of ion implantation in the ion implantation step wherein the stencil mask is used.

For example, when the accelerating energy is 1 MeV, the thickness of the protective film 3 has to be 2 to 5 µm or so. Note that the thickness of the protective film 3 changes also in accordance with a kind of ions to be implanted. Also, the required thickness of the protective film 3 is generally proportional to the accelerating energy.

Next, as shown in FIG. 3L, an ultraviolet ray having a wavelength of 356 nm (i-line) is irradiated to the opposite side surface of the protective film 3 of the membrane 2. Note that when the protective film 3 has photosensitivity, an ultraviolet ray other than the i-line may be irradiated. Alternately, an electron beam or other charged particle beam may be irradiated. The irradiated i-line is blocked by the membrane 2, and only the protective film 3 in the hole 4 portions is exposed.

After that, by developing the protective film 3, the protective film 3 in the portion exposed in the step shown in FIG. 3L is solubilized, and holes are formed in a self-aligning way in the holes 4 on the membrane 2. From the above steps, a stencil mask 1 of the present embodiment shown in FIG. 2 is obtained.

Instead of forming holes 4 by performing exposure and development on the protective film 3 as above, the holes 4 may be formed by performing dry etching on the protective film 3. In this case, after adhering the protective film 3 as shown in FIG. 3K, an oxygen plasma is irradiated on the membrane 2 from the opposite side to the protective film 3 to form holes 4 in the protective film 3. In the dry etching, an etching gas being inactive against silicon, which is a material of the membrane, and active against PMMA or other organic resin, which is a material of the protective film 3, is used. For example, oxygen may be mentioned as an etching gas as such.

### Embodiment 2

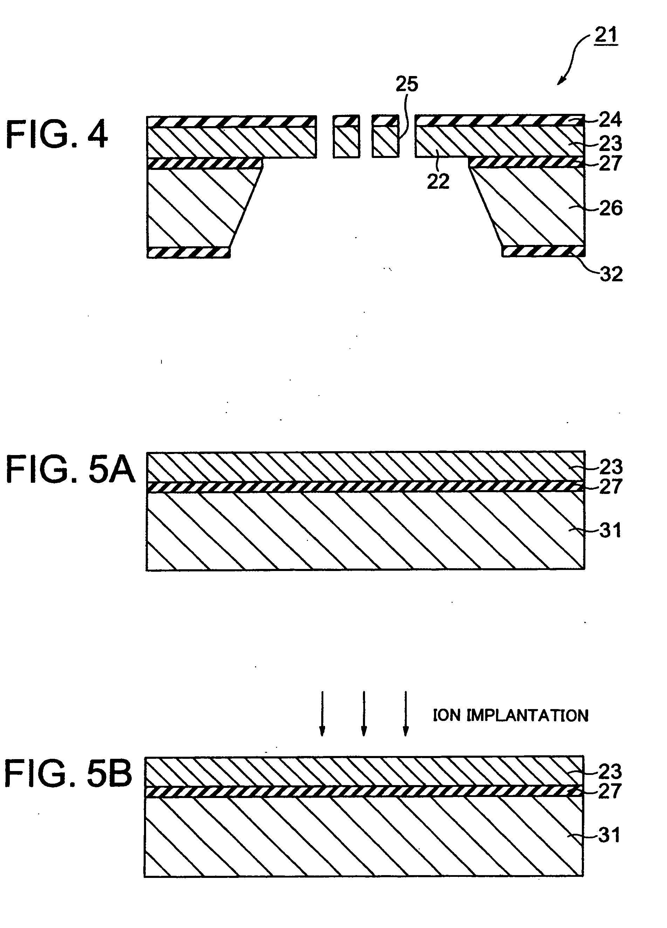

FIG. 4 is a sectional view of a mask of the present embodiment. In a stencil mask 21, a multilayer film is used as a membrane 22. Here, the membrane 22 is composed of two layers: a polysilicon layer 23 as a first thin film and a silicon nitride film 24 as a second thin film. The polysilicon layer 23 and the silicon nitride film 24 are under stress control by ion implantation in a production process of the stencil mask. The membrane 22 is formed with holes 25 for an ion beam to pass through. The ion beam is irradiated on the polysilicon layer 23 side, passed through the holes 25, and implanted at desired position in a semiconductor substrate arranged on the silicon nitride film 24 side.

The membrane 22 is supported by a frame 26. A silicon oxide film 27 between the polysilicon layer 23 and the frame 26 is used as an etching stopper layer in a step of forming the frame 26. The polysilicon layer 23 is formed to be a sufficient thickness to stop ions to be implanted when using the stencil mask 21 in the ion implantation.

Next, a method of producing the mask of the above present embodiment will be explained with reference to FIGs. 5A to 5H. First, as shown in FIG. 5A, a silicon oxide film 27 is formed on the silicon substrate 31, and the polysilicon layer 23 is formed thereon. The silicon oxide film 27 is formed, for example, to be a thickness of 100 nm or so.

A thickness of the polysilicon layer 23 is, for example, made to be 10 µm. The thickness of the polysilicon layer 23 is set in accordance with accelerating energy of ion implantation using the stencil mask 21. While being changed more or less in accordance with a kind of ions to be implanted, the polysilicon layer 23 is generally formed to be a thickness of 1 to 5 µm or so when the accelerating energy is 1 MeV. A required thickness of the polysilicon layer 23 is proportional to the accelerating energy of ion implantation.

Next, as shown in FIG. 5B, ion implantation with a predetermined dose amount is performed on the polysilicon layer 23, and the internal stress is made to be almost zero. Generally, the internal stress is changed to the compressing direction when ions having a larger radius than that of atoms composing the basic material are implanted, and to the drawing direction when the ions having a smaller radius are implanted. A relationship of an amount of ion implantation and internal stress has been studied well in experiments, and the ideal model has been also established (refer to, for example, A. Degen et al., Proc. SPIE 3997,395 (2000)).

After performing ion implantation on the polysilicon layer 23, crystallinity of the polysilicon layer 23 is recovered by performing annealing. Also, by performing annealing, ions are homogeneously dispersed in the polysilicon layer 23. By making the internal stress in the polysilicon layer 23 to almost zero, deformation of the membrane can be suppressed to minimum even when ions are implanted to the polysilicon layer 23 when using the stencil mask 21 in ion implantation. Consequently, damages on the membrane due to distortion of a pattern of the stencil mask 21 and unevenness of the internal stress can be prevented.

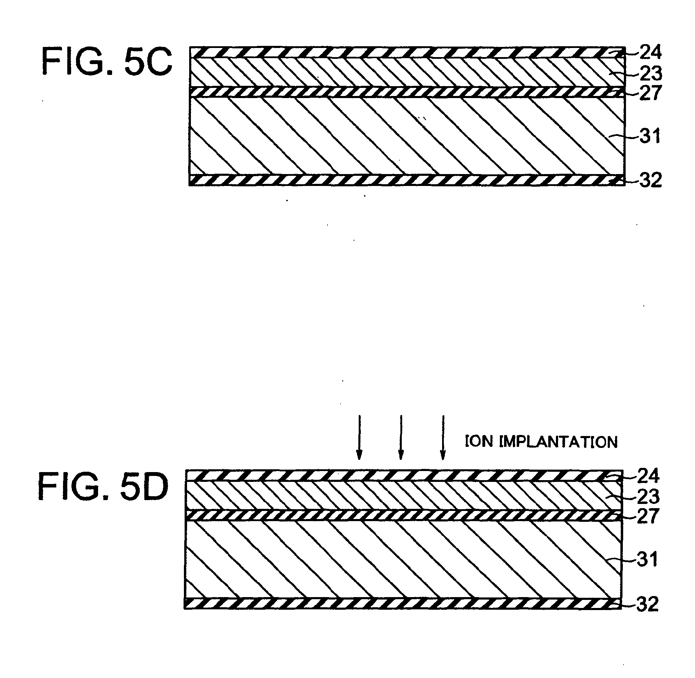

Next, as shown in FIG. 5C, silicon nitride films 24 and 32 are formed on both surfaces of the multilayer body. The silicon nitride film 24 supports the polysilicon layer 23 in the membrane 22 portion (refer to FIG. 4). When a thickness and internal stress of the silicon nitride film 24 are less than respective predetermined values, the membrane bends and distortion of the pattern is caused.

A thickness and internal stress required to the silicon nitride film 24 are determined in accordance with the membrane size. For example, when the membrane size is 200 mm square, it is necessary that the thickness of the silicon nitride film 24 is 500 nm and the internal stress is 10 MPa so as not to cause any bend in the membrane.

The silicon nitride film 24 is subjected to ion implantation as shown in FIG. 5D, so that the internal stress of the silicon nitride film 24 becomes the above value. After that, ion concentration in the silicon nitride film 24 is made to be homogenous by performing annealing. As ions to be implanted to the polysilicon layer 23 and the silicon nitride film 24, for example, phosphorous, boron and arsenic, etc. may be mentioned.

Note that when the material of the first thin film and the second thin film is changed, it is not always necessary to perform ion implantation and annealing on both of the first thin film and the second thin film to adjust the internal stresses, and ion implantation and annealing may be performed only on either one of the first thin film and the second thin film as far as the internal stress of the membrane can be controlled to be a desired value.

Next, as shown in FIG. 5E, a resist is formed to be a pattern of the frame 26 (refer to FIG. 4) on the silicon nitride film 32 on the back surface side of the silicon substrate 31, and the resist is used as a mask to perform etching on the silicon nitride film 32. After that, the resist is removed.

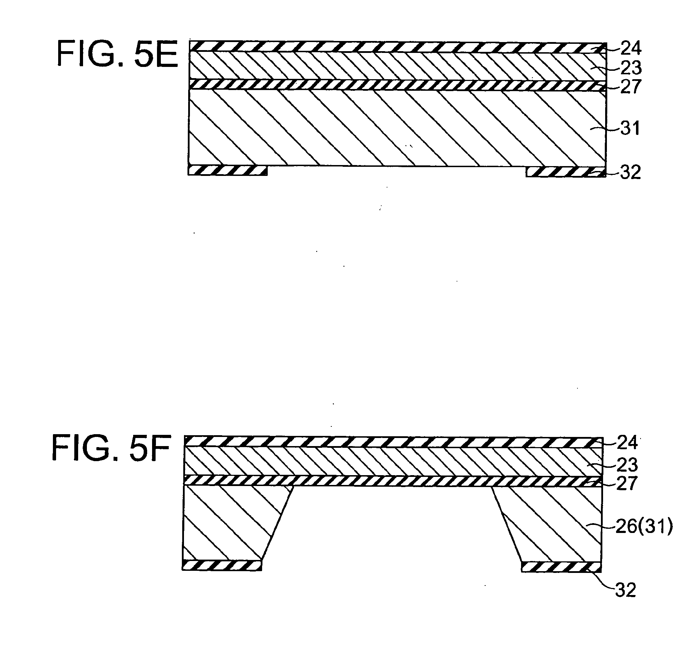

Next, as shown in FIG. 5F, the silicon nitride film 32 is used as a mask for performing etching on the silicon substrate 31. As a result, a frame 26 is formed. Etching on the silicon substrate 31 is performed by wet etching or dry etching in the same way as in the embodiment 1. Here, the silicon oxide film 27 is used as an etching stopper layer.

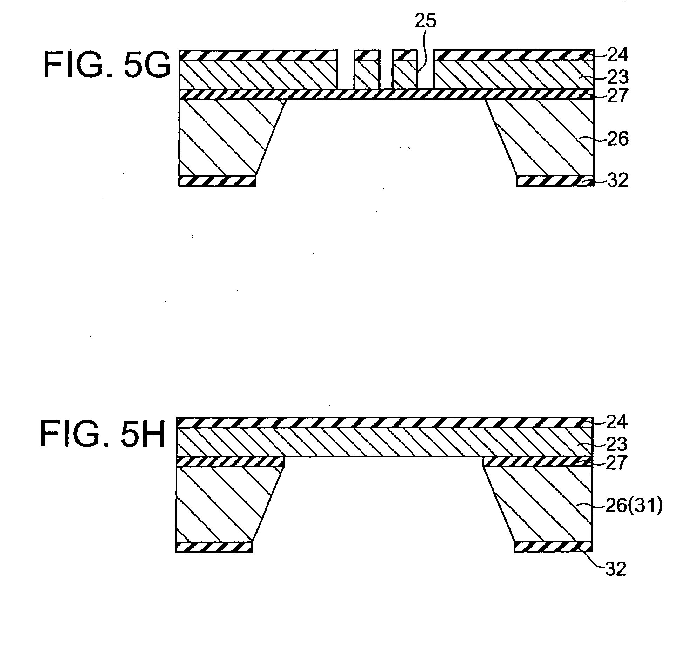

Next, as shown in FIG. 5G, dry etching is performed on the silicon nitride film 24 and the polysilicon layer 23 to form holes 25. The etching is performed by forming a resist on the silicon nitride film 24 and using the resist as a mask. After the etching, the resist on the silicon nitride film 24 is removed.

After that, dry etching or wet etching is performed on the silicon oxide film 27 from the side formed with the frame 26. As a result, the silicon oxide film 27 on the membrane 22 portion is removed, and a stencil mask 21 shown in FIG. 4 is obtained.

Also, as shown in FIG. 5F, after performing etching on the silicon substrate 31, the silicon oxide film 27 on the membrane portion may be removed before forming the holes 25. In this case, as shown in FIG. 5H, dry etching or wet etching is performed on the silicon oxide film 27 from the back surface side (the frame 26 side) to remove the silicon oxide film 27 on the membrane portion. For example CF₄ can be used for the dry etching. For example, fluorinated acid (HF) may be used for the wet etching.

After that, a resist is formed on the silicon nitride film 24, the resist is used as a mask for performing dry etching on the silicon nitride film 24 and the polysilicon layer 23 to form the holes 25, then, the resist is removed. The membrane 22 having the holes 25 may be also formed in this way.

According to the mask of the embodiment of the present invention explained above, the polysilicon layer 23 composing the membrane 22 is formed to be a sufficient thickness for absorbing accelerating energy of ion implantation. Also, internal stresses of the polysilicon layer 23 and the silicon nitride film 24 are optimized by ion implantation. As a result, it is possible to prevent the membrane from being damaged by ions to be implanted when using the mask for ion implantation.

### Embodiment 3

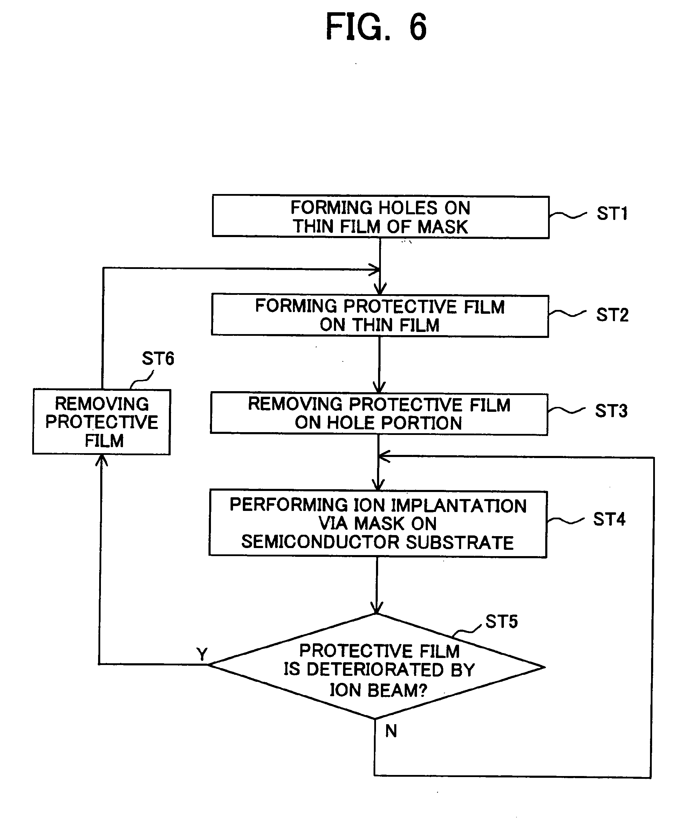

A method of producing a semiconductor device of the present embodiment includes a step of performing ion implantation by using the stencil mask in the above embodiment 1 and not by using a resist. FIG. 6 shows a flowchart of a method of producing a semiconductor device of the present embodiment. As shown in FIG. 6, in a step 1 (ST1), holes are formed on a thin film of the mask. In a step 2 (ST2), a protective film is formed on the thin film. In a step 3 (ST3), the protective film in the hole portions is removed. In a step 4 (ST4), ion implantation is performed via the mask on the semiconductor substrate.

When the protective film is deteriorated in a step 5 (ST5), the protective film is removed in a step 6 (ST6). The protective film can be peeled off, for example, by performing ashing by oxygen plasma and washing processing. The thin film after removing the protective film therefrom is again formed with a protective film (step 2) by the steps shown in FIG. 3K to FIG. 3L, and the mask is used in the subsequent ion implantation step. When the protective film is not deteriorated by an ion beam in the step 5, the mask is used again for an ion implantation step (step 4).

When ion implantation is performed by using the stencil mask in the embodiment 1, ions are stopped by the protective film 3. Accordingly, deterioration of the membrane 2 is prevented. Namely, a lifetime of the mask can be enhanced and the repetitious use becomes possible, so that a production cost of a semiconductor device can be reduced.

Also, according to the method of producing a semiconductor device of the present embodiment, a lithography step for resist formation and a resist peeling step after ion implantation are unnecessary, a turnaround time (TAT) of producing a semiconductor device is reduced, and the production cost can be largely reduced.

### Embodiment 4

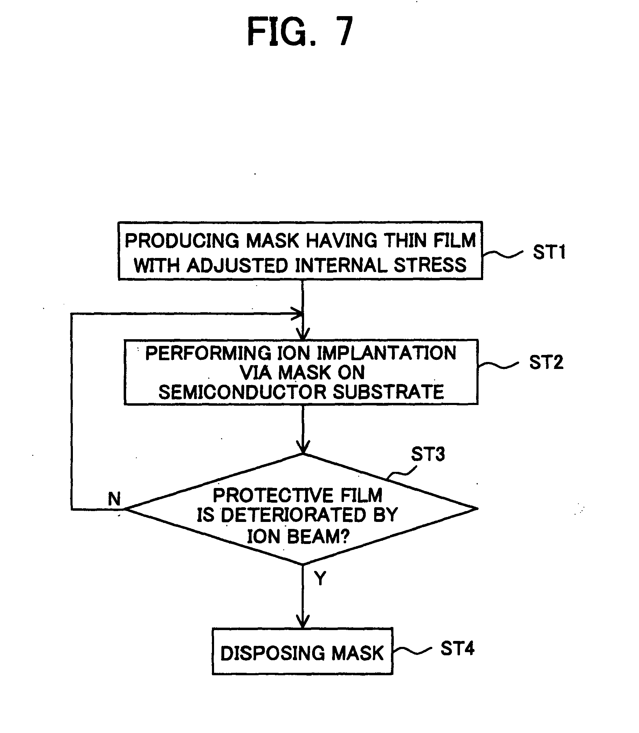

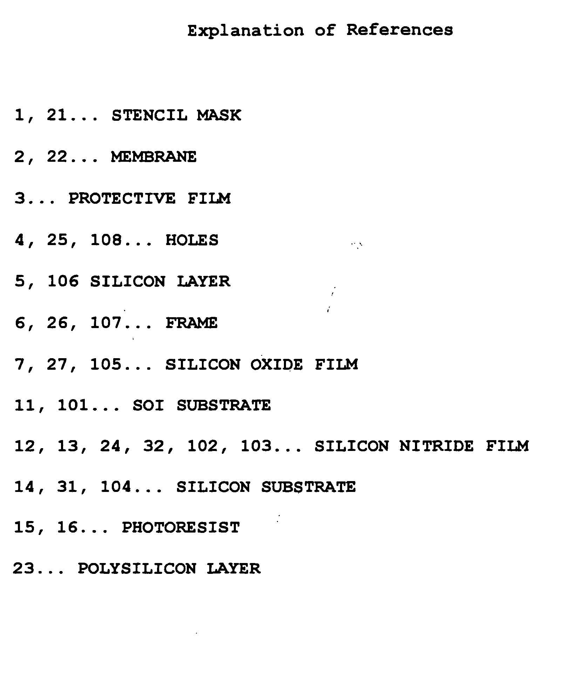

A method of producing a semiconductor device of the present embodiment includes a step of performing ion implantation by using the stencil mask of the above embodiment 2 and not by using a resist. FIG. 7 shows a flowchart of a method of producing a semiconductor device of the present embodiment. As shown in FIG. 7, in a step 1 (ST1), a mask having a thin film wherein the internal stress is adjusted is produced. In a step 2 (ST2), ion implantation is performed via the mask on the semiconductor substrate. When the membrane is not deteriorated by an ion beam in a step 3 (ST3), the mask can be used again in the ion implantation step (step 2). When the membrane is deteriorated by the ion beam in the step 3, the mask is disposed in a step 4 (ST4).

When ion implantation is performed by using the stencil mask of the embodiment 2, ions are stopped by the polysilicon layer 23. Since the internal stress of the membrane 22 is suitably controlled, deterioration of the membrane 22 is prevented even when ions are implanted to the polysilicon layer 23. As a result, a lifetime of the mask can be enhanced and the repetitious use becomes possible, so that a production cost of a semiconductor device can be reduced.

Also, according to the method of producing a semiconductor device of the present embodiment, a lithography step for resist formation and a resist peeling step after ion implantation are unnecessary, the TAT of producing a semiconductor device is reduced, and the production cost can be largely reduced.
Embodiments of the mask, the method of producing the same and the method of producing the semiconductor device of the present invention are not limited to the above explanations. For example, the mask of the present invention can be also used in other processes using a charged particle beam, for example, in ion beam lithography or electron beam lithography. Also, the mask of the present invention can be also suitably used in a process of irradiating a electromagnetic wave, such as an X-ray, EUV (extreme ultraviolet) ray, an ultraviolet ray and other light, instead of a charged particle beam to an exposure object with a predetermined mask pattern. Other than that, a variety of modifications may be made within the scope of the present invention.

According to the mask of the present invention, durability of the mask irradiated with a charged particle beam is improved. According to the method of producing the mask of the present invention, it is possible to produce a mask having sufficient strength against a charged particle beam.

According to the method of producing a semiconductor device of the present invention, costs and time required for an ion implantation step can be largely reduced.

## Claims

1. A mask comprising:
a thin film;
a protective film formed on a part of the thin film;
a supporting frame formed on the thin film to surround the protective film; and
holes formed in the thin film and the protective film for allowing a charged particle beam or a electromagnetic wave irradiated on the protective film side to pass.

2. A mask as set forth in claim 1, wherein
the charged particle beam is an ion beam.

3. A mask as set forth in claim 1, wherein
a thickness of the protective film is determined in accordance with accelerating energy of ion implantation in an ion implantation step wherein the mask is used.

4. A mask as set forth in claim 1, wherein
a material of the protective film includes a photosensitive resin.

5. A mask comprising:
a first thin film;
a supporting frame formed on a part of a first surface of the first thin film;
a second thin film formed on a second surface of the first thin film; and
holes formed in the first and second thin films in a portion surrounded by the supporting frame for allowing a charged particle beam or a electromagnetic wave irradiated on the first surface side to pass;
wherein impurities are introduced into at least one of the first thin film and the second thin film to control a internal stress thereof.

6. A mask as set forth in claim 5, wherein
the charged particle beam is an ion beam.

7. A mask as set forth in claim 5, wherein
a thickness of the first thin film is determined in accordance with accelerating energy of ion implantation in an ion implantation step wherein the mask is used.

8. A mask as set forth in claim 5, wherein
a thickness of the second thin film and the internal stress are determined in accordance with a size of a portion surrounded by the supporting frame.

9. A mask as set forth in claim 5, wherein
the impurities are introduced by an ion implantation, and annealing is performed after the ion implantation introducing the impurities into at least one of the first thin film and the second thin film.

10. A method of producing a mask comprising the steps of:
forming a thin film on a substrate via a sacrificial film;
forming a supporting frame made by the substrate by removing a part of the substrate until the sacrificial film is exposed;
forming first holes in the thin film in a portion where the supporting frame is not formed;
removing the sacrificial film in the portion where the supporting frame is not formed;
forming a protective film on a first surface of the thin film being supporting frame side in the portion where the supporting film is not formed;
forming second holes self-aligned to the first holes in the protective film.

11. A method of producing a mask as set forth in claim 10, wherein
the step of forming the protective film includes a step of adhering a photosensitive resin film, and
the step of forming the second holes includes a step of exposing the protective film from a second surface of the thin film via the first holes and a step of developing the protective film thereby an exposed portion is removed.

12. A method of producing a mask se set forth in claim 10, wherein
the step of forming the second holes includes a step of performing an etching on the protective film by using the thin film as a mask.

13. A method of producing a mask as set forth in claim 10, wherein
the step of removing the sacrificial film in the portion where the supporting frame is not formed is performed after the step of forming the first holes.

14. A method of producing a mask comprising the steps of:
forming a first thin film on a substrate via a sacrificial film;
introducing impurities into the first thin film for adjusting an internal stress of the first thin film;
forming a second thin film on the first thin film;
forming a supporting frame made by the substrate by removing a part of the substrate until the sacrificial film is exposed;
forming holes in the first thin film and the second thin film in a portion where the supporting frame is not formed;
removing the sacrificial film in the portion where the supporting frame is not formed.

15. A method of producing a mask as set forth in claim 14,
further comprising a step of introducing impurities into the second thin film for adjusting an internal stress of the second thin film after the step of forming the second thin film and before the step of forming the supporting frame.

16. A method of producing a mask as set forth in claim 14, wherein
the step of removing the sacrificial film in the portion where the supporting frame is not formed is performed before the step of forming the holes.

17. A method of producing a mask comprising the steps of:
forming a first thin film on a substrate via a sacrificial film;
forming a second thin film on the first thin film;
introducing impurities into the second thin film for adjusting an internal stress of the second thin film;
forming a supporting frame made by the substrate by removing a part of the substrate until the sacrificial film is exposed;
forming holes in the first thin film and the second thin film in a portion where the supporting frame is not formed;
removing the sacrificial film in the portion where the supporting frame is not formed.

18. A method of producing a mask as set forth in claim 17, wherein
the step of removing the sacrificial film in the portion where the supporting frame is not formed is performed before the step of forming the holes.

19. A method of producing a semiconductor device including a step of performing an ion implantation via a mask on a desired portion of a substrate, wherein
a mask comprising:
a thin film;
a protective film formed on a part of the thin film;
a supporting frame formed on the thin film to surround the protective film; and
holes formed in the thin film and the protective film for allowing a charged particle beam or a electromagnetic wave irradiated on the protective film side to pass
is used as the mask.

20. A method of producing a semiconductor device including a step of performing an ion implantation via a mask on a desired portion of a substrate, wherein
a mask comprising:
a first thin film;
a supporting frame formed on a part of a first surface of the first thin film;
a second thin film formed on a second surface of the first thin film; and
holes formed in the first and second thin films in a portion surrounded by the supporting frame for allowing a charged particle beam or a electromagnetic wave irradiated on the first surface side to pass;
wherein impurities are introduced into at least one of the first thin film and the second thin film to control a internal stress thereof
is used as the mask.
